## Europäisches Patentamt

## European Patent Office

## Office européen des brevets

(19)

(11) Veröffentlichungsnummer: **0 142 077**
**B1**

(12) # EUROPÄISCHE PATENTSCHRIFT

(45) Veröffentlichungstag der Patentschrift:
**04.01.89**

(51) Int. Cl.⁴: **G 01 N 24/04**, G 01 N 24/08

(21) Anmeldenummer: **84112771.5**

(22) Anmeldetag: **23.10.84**

(54) **Hochfrequenz-Einrichtung einer Kernspinresonanz-Apparatur mit einer Oberflächenspule.**

(30) Priorität: **08.11.83 DE 3340384**

(43) Veröffentlichungstag der Anmeldung:
**22.05.85 Patentblatt 85/21**

(45) Bekanntmachung des Hinweises auf die Patenterteilung:
**04.01.89 Patentblatt 89/1**

(84) Benannte Vertragsstaaten:
**DE FR GB NL**

(56) Entgegenhaltungen:
**EP-A-0 071 896**
**EP-A-0 142 079**
**GB-A-2 056 066**
**GB-A-2 082 775**
**GB-A-2 094 482**
**US-A-4 240 439**
**US-A-4 411 270**

(73) Patentinhaber: **Siemens Aktiengesellschaft Berlin und München, Wittelsbacherplatz 2, D-8000 München 2 (DE)**

(72) Erfinder: **Krause, Norbert, Dr., Weinbergstrasse 29, D-8551 Heroldsbach (DE)**

EP 0 142 077 B1

## Beschreibung

Die Erfindung bezieht sich auf eine Einrichtung zur Erzeugung eines magnetischen Hochfrequenz-Feldes und/oder zum Empfang entsprechender Hochfrequenz-Signale in einer Kernspinresonanz-Apparatur, insbesondere der medizinischen Technik. Die Einrichtung enthält eine Oberflächenspule mit mehreren Windungen zum Erzeugen eines im Wesentlichen in Richtung einer y-Achse senkrecht zur Oberfläche eines zu untersuchenden Körpers orientierten magnetischen Hochfrequenzfeldes. Die Oberflächenspule ist innerhalb eines wenigstens annähernd homogenen, längs einer z-Achse parallel zur Oberfläche des Körpers orientierten magnetischen Grundfeldes an der Oberfläche des Körpers anzuordnen. Eine derartige Einrichtung ist aus US-A-4 240 439 bekannt.

Insbesondere auf dem Gebiet der medizinischen Technik sind Diagnoseverfahren entwickelt worden, bei denen rechnerisch oder meßtechnisch integrale Resonanzsignale von Kernen eines bestimmten Elementes aus der Spindichteverteilung und/oder aus der Relaxationszeitenverteilung eines zu untersuchenden Körpers bzw. Körperteiles analysiert werden. Solche Verfahren sind bekannt unter der Bezeichnung "Kernspintomographie" KST, NMR-Tomography (nuclear magnetic resonance) oder "Zeugmatographie".

Voraussetzung für die Kernspintomographie ist ein von einem so genannten Grundfeldmagneten erzeugtes starkes Magnetfeld, das in einem Bereich vorbestimmter Ausdehnung möglichst homogen ist und in das der zu untersuchende Körper bzw. der Körperteil längs einer Achse, die im allgemeinen mit der Orientierungsachse des magnetischen Grundfeldes übereinstimmt, eingebracht wird. Zur Anregung der Atomkerne eines vorbestimmten Elementes in dem Körper zu einer Präzessionsbewegung ist außerdem eine besondere Spule erforderlich, mit der kurzzeitig ein hochfrequentes magnetisches Wechselfeld (HF-Wechselfeld) erzeugt werden und die auch zum Empfang der damit verbundenen HF-Signale dienen kann, falls keine besondere Meßspule vorgesehen wird. Gegebenenfalls kann das Grundfeld lokal auch variiert werden, um damit den Bereich, der durch das hochfrequente Signal der Oberflächenspule angeregt wird, zu beschränken (Topological NMR; Sensitive Point Method).

Für spezielle Apparaturen, mit denen beispielsweise die im menschlichen Körper im Vergleich zu den $^1$H-Kernen verhältnismäßig wenig auftretenden $^{31}$P-Kerne oder $^{13}$C-Kerne angeregt bzw. deren Kernspinresonanzsignale empfangen werden, sind HF-Spulen bekannt, die aus Gründen einer ausreichend großen Empfindlichkeit in oberflächennahen Körperbereichen angeordnet, d. h. insbesondere auf die Körperoberfläche aufgelegt werden. Als hierfür geeignete HF-Spulen, die deshalb auch als Oberflächenspulen bezeichnet werden, verwendet man im allgemeinen kreisringförmige Wicklungen mit einer einzigen oder mehreren Windungen.

Derartige Oberflächenspulen haben jedoch ihr Empfindlichkeitsmaximum in oberflächennahen Bereichen. Will man aber speziell tiefergelegene Körperteile mit diesen Spulen untersuchen, in denen deren Empfindlichkeit vergleichsweise geringer ist, so läßt sich nicht vermeiden, daß die zu gewinnenden Resonanzsignale stets von den verhältnismäßig starken Signalen aus den oberflächennahen Bereichen überlagert sind. Die Signalanalyse ist somit entsprechend erschwert.

Aufgabe der vorliegenden Erfindung ist es deshalb, die eingangs genannte Hochfrequenz-Einrichtung dahingehend zu verbessern, daß die Empfindlichkeit ihrer Oberflächenspule in Tiefenrichtung so einstellbar ist, daß verhältnismäßig starke Resonanzsignale insbesondere von tiefergelegenen Teilen des zu untersuchenden Körpers zu gewinnen sind.

Diese Aufgabe wird erfindungsgemäß gelöst mit den kennzeichnenden Merkmalen des Anspruchs 1. Die mit dieser Ausgestaltung der Hochfrequenz-Einrichtung verbundenen Vorteile sind insbesondere darin zu sehen, daß man durch die zusätzlichen äußeren Windungen und die Gruppenbildung der aktiven Teile ihrer Längsleiterstücke sowie ihre Anordnung bezuglich der inneren Windung eine ausgeprägte Richtcharakteristik in Tiefenrichtung senkrecht zur Oberfläche des zu untersuchenden Körpers erhält. Es lassen sich somit charakteristische Zonen höherer und niedrigerer Empfindlichkeit bezüglich der Körpertiefe erreichen.

Vorteilhafte Ausgestaltungen der erfindungsgemäßen Hochfrequenz-Einrichtung gehen aus den Unteransprüchen hervor.

Zur weiteren Erläuterung der Erfindung wird auf die Zeichnung Bezug genommen.

Figur 1 zeigt schematisch die Anordnung einer HF-Oberflächenspule.

In Figur 2 ist in einem Diagramm der sich für diese Spule in einer speziellen Schnittebene ergebende Verlauf von Linien konstanter HF-Signalfeldstärke wiedergegeben.

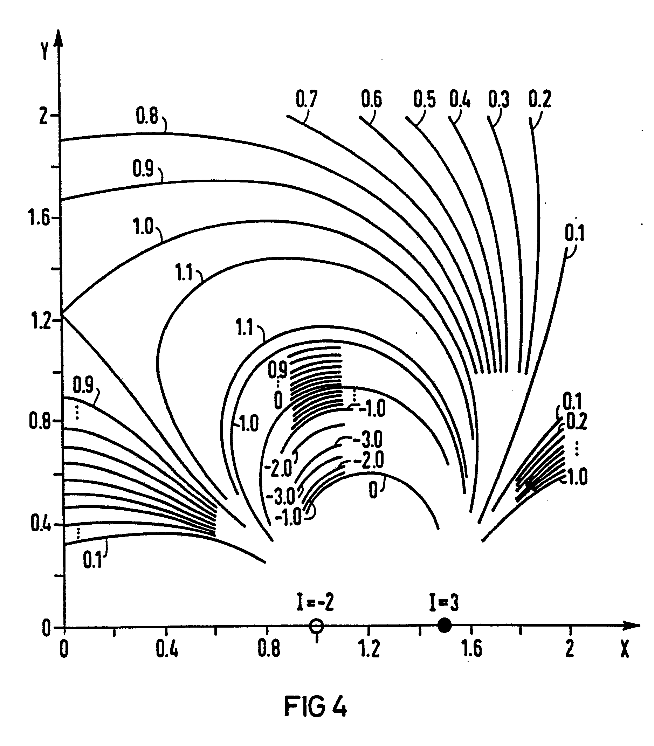

In Figur 3 ist eine vorteilhafte Ausführungsform einer Oberflächenspule gemäß der Erfindung veranschaulicht und

aus Figur 4 gehen die sich für diese Spule ergebenden Signalfeldstärkeverhältnisse hervor.

In Fig. 5 ist eine weitere Ausgestaltungsmöglichkeit der Oberflächenspule angedeutet.

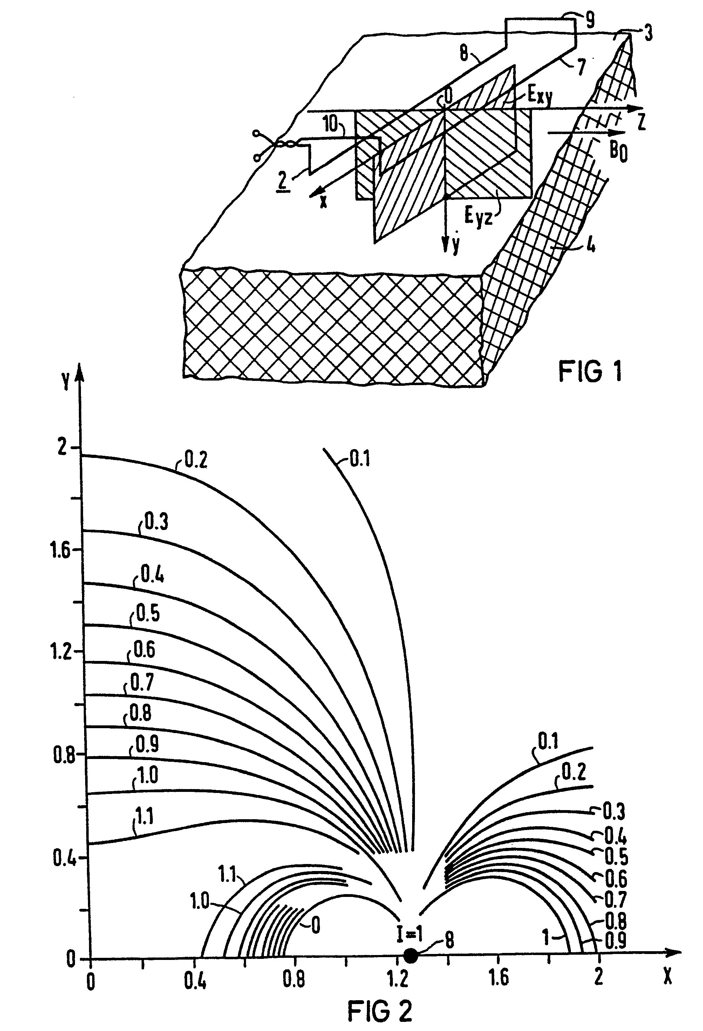

Figur 1 zeigt eine Oberflächenspule, wie sie in der denselben Prioritätstag aufweisenden Parallelanmeldung EP-A-0 142 079 vorgeschlagen ist. Diese allgemein mit 2 bezeichnete Spule enthält eine einzige Windung, deren Leiterteile symmetrisch zu einem Punkt 0 auf der Oberfläche 3 eines zu untersuchenden Körpers oder Körperteiles 4 zumindest teilweise aufgelegt sind. Dieser Körperteil befindet sich in bekannter Weise in einem wenigstens annähernd

homogenen magnetischem Grundfeld $B_0$ einer in der Figur nicht dargestellten Kernspinresonanz-Apparatur. Durch den Punkt 0 ist ein rechtwinkliges x-y-z-Koordinatensystem so gelegt, daß die z-Achse in die Orientierungsrichtung des magnetischen Grundfeldes $B_0$ weist. Außerdem sind in der Figur die x-y-Ebene und die y-z-Ebene näher veranschaulicht und mit $E_{xy}$ bzw. $E_{yz}$ bezeichnet. Mit einem hochfrequenten Wechselstrom 1 durch die Oberflächenspule 2 wird dann ein für entsprechende Resonanzexperimente erforderliches kurzzeitiges HF-Feld der Feldstärke $B_1$ erzeugt. Die Oberflächenspule kann hierbei auch als Empfänger für die nach dem Abschalten des HF-Feldes zu empfangenden HF-Signale aus dem Inneren des Körperteiles 4 dienen.

Die Oberflächenspule 2 hat gemäß dem gewählten Ausführungsbeispiel eine rechteckförmige Gestalt. Sie kann aber auch runde, beispielsweise ovale oder kreisringförmige Gestalt haben. Auf Grund der in der Figur angenommenen Form weist die Spule 2 zwei parallele Längsleiterstücke 7 und 8 auf, zuischen denen Querleiterstücke 9 und 10 verlaufen. Die Spule 2 ist dabei so bezüglich des magnetischen Grundfeldes $B_0$ ausgerichtet, daß ihre Längsleiterstücke 7 und 8 zumindest annähernd rechtwinklig zu diesem Feld verlaufen. Die gegenüber den Längsleiterstücken 7 und 8 wesentlich kürzeren Querleiterstücke 9 und 10 liegen somit im wesentlichen parallel zu diesem Grundfeld. Auf Grund dieser Ausrichtung der Längsleiterstücke 7 und 8 wird nämlich vorteilhaft erreicht, daß in jeder y-z-Querschnittsebene annähernd die gleiche Feldcharakteristik bei der Abstrahlung der HF-Signale ausgebildet wird. Entsprechendes gilt auch für den Empfangsfall. Es läßt sich dann erreichen, daß die empfangenen HF-Signale eindeutiger einem Bereich zuzuordnen sind, der durch die geometrische Ausdehnung der Fläche zwischen den Längsleiterstücken der Spule begrenzt wird.

Vorteilhaft sind die Längsleiterstücke 7 und 8 mindestens dreimal länger als die Querleiterstücke 9 und 10. Um Endeffekte der Spule 2 zu reduzieren, sind außerdem vorteilhaft die Querleiterstücke 9 und 10 von der Körperoberfläche 3 abgehoben angeordnet, so daß sie sich in größerer Entfernung zu der Signalquelle in dem Körperteil 4 befinden als vergleichsweise die beiden Längsleiterstücke 7 und 8. Neben dieser in der Figur dargestellten Maßnahme zur Reduzierung von Endeffekten können auch 5 andere Maßnahmen wie z. B. eine hochfrequenzmäßige Abschirmung der Querleiterstücke vorgesehen werden.

Da das hochfrequente Wechselfeld der Oberflächenspule 2 mit der Feldstärke $B_1$ von dem ganz wesentlich stärkeren magnetischen Grundfeld $B_0$ überlagert wird, folgt daraus, daß die Komponenten des sehr viel schwächeren hochfrequenten Wechselfeldes, welche mit der Orientierungsrichtung des Grundfeldes $B_0$

übereinstimmen, praktisch unwirksam sind. Für die mit der Oberflächenspule 2 zu empfangenden HF-Signale ergibt sich dann z. B. in der transversalen x-y-Ebene $E_{xy}$ ein Verlauf von Linien konstanter wirksamer Signalstärke, wie er aus dem Diagramm der Fig. 2 hervorgeht. In diesem Diagramm mit Ortskoordinaten in willkürlichen Einheiten sind die zu ermittelnden relativen Signalstärkeverhältnisse der empfangenen HF-Signale an den jeweiligen Kurven eingetragen. Die Signalstärke wird dabei nach einem 90°-Impuls als Produkt aus $B_1$ und sin (const. · $B_1$) ermittelt.

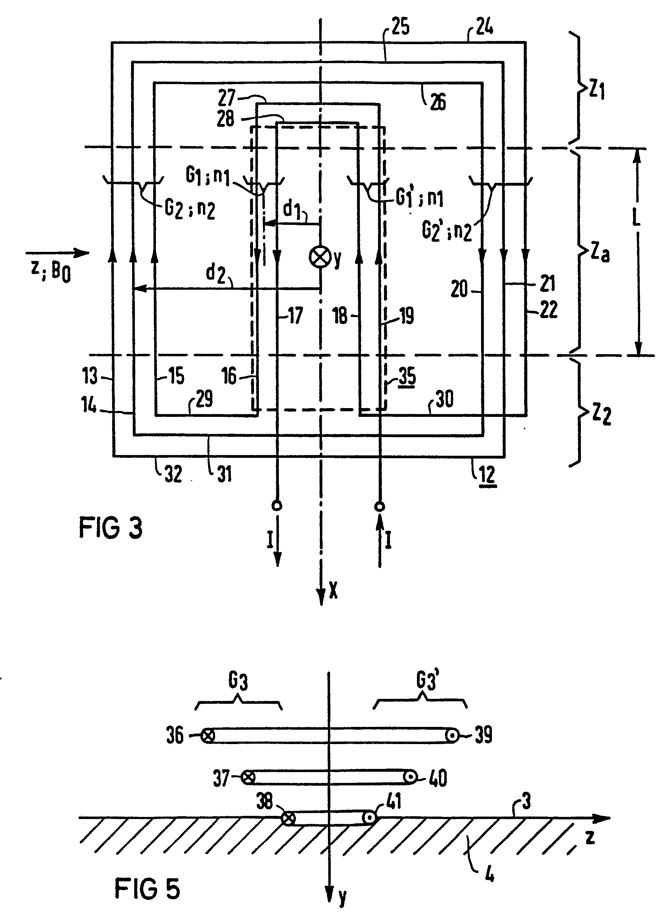

Wie aus dem Diagramm der Fig. 2 ohne weiteres ersichtlich ist, liegt bei der Oberflächenspule 2 gemäß Fig. 1 der Bereich größter Signalstärke und damit größter Empfindlichkeit bei verhältnismäßig kleinen y-Werten, d. h. in Nähe der Oberfläche 3 des zu untersuchenden Körperteiles 4. Die damit verbundenen Schwierigkeiten hinsichtlich der Untersuchung von tiefergelegenen Körperteilen lassen sich mit der erfindungsgemäßen Ausgestaltung der HF-Oberflächenspule wesentlich verringern. Ein Ausführungsbeispiel einer derartigen Spule geht aus Fig. 3 näher hervor, wobei mit Fig. 1 übereinstimmende Teile mit den gleichen Bezugszeichen versehen sind.

Bei dem in 3 gezeigten Ausführungsbeispiel einer erfindungsgemäßen, allgemein mit 12 bezeichneten Oberflächenspule ist davon ausgegangen, daß sie eine rechteckige Form hat. Ebenso kann sie jedoch auch eine runde, beispielsweise ovale oder kreisringförmige Gestalt haben. Die Spule 12 ist in x-Richtung langgestreckt ausgeführt, d. h. ihre zumindest annähernd parallel zur x-Achse ausgerichteten Längsleiterstücke 13 bis 22 sind wesentlich, vorzugsweise mindestens dreimal länger als ihre jeweils zugeordneten Querleiterstücke 24 bis 32. Außerdem sind die Querleiterstücke von der Oberfläche des Körperteiles entweder entsprechend Fig. 1 abgehoben oder aber abgeschirmt angeordnet, so daß zwischen zwei Zonen $Z_1$ und $Z_2$ mit abgehobenen oder abgeschirmten Leiterstücken die Oberflächenspule 12 nur mit ihren Längsleiterstücken 13 bis 22 in einer aktiven Zone $Z_a$ auf der Körperoberfläche aufliegt. Hierbei wird definitionsgemäß sowohl die Anordnung der Längsleiterstücke 13 bis 22 unmittelbar auf der Körperoberfläche 3 als auch in geringer Entfernung von beispielsweise einigen Zentimetern über derselben verstanden.

Die aktiven Teile der einzelnen Windungen der Oberflächenspule 12 werden von zu Gruppen zusammengefaßten, unmittelbar neben- oder aufeinander liegenden Längsleiterstücken mit gleicher Stromflußrichtung gebildet. So enthält die Spule zwei Gruppen $G_1$ und $G'_1$ aus den Längsleiterstücken 16 und 17 bzw. 18 und 19, die jeweils symmetrisch zur x-Achse von dieser mit einem mittleren Abstand $d_1$ entfernt angeordnet sind. Die Anzahl von Längsleiterstücken in diesen Gruppen ist mit $n_1$ bezeichnet. Die

Längsleiterstücke 16 bis 19 bilden quasi eine durch eine punktierte Linie angedeutete innere Teilwicklung 15, welche von einer äußeren Teilwicklung umschlossen ist. Der aktive Teil dieser äußeren Teilwicklung wird von zwei Gruppen $G_2$ und $G'_2$ mit jeweils den Längsleiterstücken 13 bis 15 bzw. 20 bis 22 gebildet. Die mittlere Entfernung dieser somit $n_2$ = 3 Längsleiterstücke enthaltenden Gruppen von der x-Achse ist mit $d_2$ bezeichnet. Die einzelnen Längsleiterstücke 13 bis 22 sind dabei über die Querleiterstücke 24 bis 32 so verbunden, daß die durch Pfeile angedeuteten Stromflußrichtungen durch die Längsleiterstücke jeder einzelnen Gruppe gleich sind, jedoch untereinander benachbarte Gruppen entgegengesetzte Stromflußrichtungen aufweisen.

Wesentlich für die Oberflächenspule 12 nach Fig. 3 ist auch, daß die Ausdehnung L der aktiven Zone $Z_a$ in x-Richtung erheblich größer gewählt wird als der Abstand $d_2$ bzw. $d_1$. Es läßt sich so gewährleisten, daß praktisch nur die y-Komponente des hochfrequenten Wechselfeldes $B_1$ wirksam ist. Darüber hinaus können gegebenenfalls die aktiven Längen der einzelnen Gruppen in Richtung der x-Achse auch unterschiedliche Größen haben, d. h., die aktive Länge der Gruppen $G_1$ und $G'_1$ kann z. B. größer oder kleiner als die aktive Länge der Gruppen $G_2$ und $G'_2$ sein. Werden ferner die Abstände $d_1$ und $d_2$ so gewählt, daß sie mit den Leiterzahlen $n_1$ und $n_2$ im Verhältnis

$$\frac{d_1}{d_2} = \frac{n_1}{n_2}$$

stehen, so ist vorteilhaft das Feld im Zentrum der Anordnung, d. h. im Koordinatenursprung praktisch vollständig ausgelöscht und die Zone maximaler Empfindlichkeit wird tiefer in das Körperinnere verlagert. D. h., die Feldstärke verläuft im Bereich dieser Tiefe in Form eines Sattelpunktes, der in diesem Fall ungefähr bei

$$\frac{d_1 + d_2}{4}$$

liegt. Auf diese Weise können beispielsweise auf dem Gebiet der medizinischen Technik eindeutigere Aussagen über tiefergelegene Körperteile wie beispielsweise innere Organe erhalten werden.

Ein entsprechendes Ausführungsbeispiel einer erfindungsgemäßen Oberflächenspule mit jeweils n = 2 Längsleiter stücken pro Gruppe ist dem Diagramm der Fig. 4 zugrundegelegt. In diesem Diagramm sind entsprechend der Darstellung des Diagrammes nach Fig. 2 die Kurven konstanter Signalstärke bei einem Schnitt in der x-y-Ebene eingetragen. Wie aus dem Diagramm insbesondere durch einen Vergleich mit dem Diagramm der Fig. 2 ersichtlich ist, liegt das Empfindlichkeitsmaximum nunmehr nicht nahe der x-Achse bei verhältnismäßig kleinen y-Werten, sondern es ist nach größeren y-Werten hin verschoben. Diese Verschiebung ist gleichbedeutend mit der Verschiebung des Empfindlichkeitsmaximums zu entsprechend größeren Körpertiefen hin.

Bei dem Ausführungsbeispiel einer Oberflächenspule nach Fig. 3 wurde davon ausgegangen, daß sich die Längsleiterstücke ihrer einzelnen Leitergruppen alle in der x-z-Ebene auf der Oberfläche 3 des zu untersuchenden Körperteiles 4 befinden sollen. Eine derartige Anordnung ist jedoch nicht unbedingt erforderlich. Wie nämlich aus dem in Fig. 5 schematisch dargestellten Schnitt in einer y-z-Ebene hervorgeht, können auch die zu den jeweiligen Gruppen gehörenden Längsleiterstücke in unterschiedlichen Ebenen liegen. In der Figur ist ein Gruppenpaar $G_3$-$G'_3$ mit jeweils drei Längsleiterstücken 36 bis 38 bzw. 39 bis 41 angenommen, wobei nur die Längsleiterstücke 38 und 41 unmittelbar auf der Oberfläche 3 des Körperteiles 4 oder in geringem Abstand von derselben zu liegen kommen.

Neben der Ausbildung der Oberflächenspule 12 nach Fig. 3 mit jeweils zwei Paaren von Leitergruppen $G_1$-$G'_1$ bzw. $G$-$G'_2$ können auch Spulen vorgesehen werden, die noch weitere, von der x-Achse weiter entfernt liegenden Gruppen von Längsleiterstücken aufweisen. Dabei muß die Anzahl n der Längsleiterstücke dieser weiter entfernt liegenden Gruppen nicht unbedingt mit zunehmendem Abstand von der x-Achse kontinuierlich zunehmen. Im allgemeinen ist es jedoch zweckmäßig, daß zumindest für die beiden der x-Achse am nächsten liegenden Gruppen $G_1$ und $G_2$ bzw. $G'_1$ und $G'_2$ die Anzahl ihrer Längsleiterstücke zunimmt, d. h. daß gilt: $n_2 > n_1$.

Neben der in Fig. 3 angedeuteten besonderen Hintereinanderschaltung der einzelnen Längsleiterstücke ist prinzipiell auch eine Parallelschaltung von Einzelspulen denkbar. Hierbei ist jedoch zu beachten, daß bei einer inhomogenen Struktur des zu untersuchenden Körperteiles auch eine unsymmetrische Aufteilung des Stromes auf die einzelnen Spulen auftreten kann.

## Patentansprüche

1. Einrichtung zur Erzeugung eines magnetischen Hochfrequenzfeldes und/oder zum Empfang entsprechender Hochfrequenzsignale in einer Kernspinresonanz-Apparatur, insbesondere der medizinischen Technik, wobei die Einrichtung eine Oberflächenspule (12) mit mehreren Windungen enthält zum Erzeugen eines im wesentlichen in Richtung der y-Achse eines x-y-z-rechtwinkligen Koordinatiensystems, senkrecht zur Oberfläche (3) eines zu untersuchenden Körpers (4) orientierten magnetischen Hochfrequenzfeldes, und wobei die Oberflächenspule (12) innerhalb eines wenigstens annähernd homogenen, längs der z-Achse, parallel zur Oberfläche (3) des Körpers (4) orientierten magnetischen Grundfeldes ($B_0$) an

der Oberfläche (3) des Körpers (4) anzuordnen ist ist,

gekennzeichnet durch folgende Gestaltungsmerkmale:

a) die Windungen (16, 19, 27; 17, 18, 28; 13, 24, 22, 29, 30; 14, 25, 21, 32; 15, 26, 20, 31) der Oberflächenspule (12) enthalten als magnetisch aktive Teile Längsleiterstücke (13 bis 22), von denen jeweils die beiden zur gleichen Windung gehörenden Längsleiterstücke (13 bzw. 22, 14 bzw. 21; 15 bzw. 20, 16 bzw. 19 und 17 bzw. 18) symmetrisch zur x-Achse angeordnet sind,

b) mehrere äußere Windungen (13, 24, 22, 29, 30; 14, 25, 21, 32; 15, 26, 20, 31) umgeben mindestens eine innere Windung (16, 19, 27; 17, 18, 28),

c) die Längsleiterstücke (13 bis 15 bzw. 20 bis 22) der äußeren Windungen (13, 24, 22, 29, 30; 14, 25, 21, 32; 15, 26, 20, 31) mit gleicher Stromrichtung in bezug auf die x-Achse bilden jeweils eine aus benachbarten Längsleiterstücken besthend äußere Gruppe (G₂; G'₂),

d) die Stromflußrichtungen dieser Gruppen (G₂, G'₂) sind in bezug auf die x-Achse einander entgegengerichtet,

e) die Stromflußrichtung jeweils einer der äußeren Gruppen (G₂, G'₂) ist der Stromflußrichtung des benachbarten Längsleiterstückes der inneren Windung entgegengerichtet.

2. Einrichtung nach Anspruch 1, dadurch gekennzeichnet, daß mehrere innere Windungen (16, 19, 27 und 17, 18, 28) vorgesehen sind, deren benachbarte Längsleiterstücke (16, 17; 18, 19) gleicher Stromrichtung in bezug auf die x-Achse jeweils eine innere Gruppe (G₁ bzw. G'₁) bilden.

3. Einrichtung nach Anspruch 1 oder 2, dadurch gekennzeichnet, daß eine Oberflächenspule (12) mit im wesentlichen rechteckiger Gestalt vorgesehen ist, deren parallel verlaufende Längsleiterstücke (13 bis 22) wesentlich länger sind als die sie verbindenden Querleiterstücke (24 bis 32), und daß die Längsleiterstücke (13 bis 22) zumindest weitgehend senkrecht zur Orientierungsrichtung des magnetischen Grundfeldes (B₀) angeordnet sind.

4. Einrichtung nach Anspruch 2 oder 3, dadurch gekennzeichnet, daß die Anzahl (n₁) der Längsleiterstücke (16 bis 19) der inneren Windungen kleiner ist als die Anzahl (n₂) der Leiterstücke (13 bis 15 und 20 bis 22) der sie umschließenden äußeren Windungen.

5. Einrichtung nach einem der Ansprüche 2 und 4, dadurch gekennzeichnet, daß die äußeren Gruppen (G₂, G'₂) und die inneren Gruppen (G₁, G'₁) jeweils symmetrisch zur x-Achse angeordnet sind.

6. Einrichtung nach einem der Ansprüche 2 bis 5, dadurch gekennzeichnet, daß die inneren Gruppen (G₁, G'₁) jeweils zwei Längsleiterstücke (16, 17 bzw. 18, 19) und die äußeren Gruppen (G₂, G'₂) jeweils drei Längsleiterstücke (13 bis 15 bzw. 20 bis 22) enthalten.

7. Einrichtung nach Anspruch 5 oder 6, dadurch gekennzeichnet, daß die Entfernung ($d_1$) der inneren Gruppen (G₁, G'₁) von der x-Achse im Verhältnis zu der entsprechenden Entfernung ($d_2$) der äußeren Gruppen (G₂, G'₂) etwa gewählt ist wie

$$\frac{d_1}{d_2} = \frac{n_1}{n_2}.$$

8. Einrichtung nach einem der Ansprüche 3 bis 7, dadurch gekennzeichnet, daß das kürzeste Längsleiterstück (13 bis 22) der Oberflächenspule (12) mindestens dreimal länger als sein jeweils zugeordnetes Querleiterstück (24 bis 32) ist.

9. Einrichtung nach einem der Ansprüche 3 bis 8, dadurch gekennzeichnet, daß die Querleiterstücke (24 bis 32) hochfrequenzmäßig abgeschirmt sind.

10. Einrichtung nach einem der Ansprüche 3 bis 8, dadurch gekennzeichnet, daß der Abstand der Querleiterstücke (24 bis 32) von der Oberfläche (3) des zu untersuchenden Körperteiles (4) größer ist als der Abstand der Längsleiterstücke (13 bis 22).

11. Einrichtung nach einem der Ansprüche 1 bis 10, dadurch gekennichnet, daß eine weiter Gruppe (G₃, G'₃) bildende benachbarte Längsleiterstücke (36 bis 38 bzw. 39 bis 41) zumindest teilweise in verschiedenen Ebenen angeordnet sind.

**Claims**

1. Device for generating a magnetic high-frequency field and/or for receiving corresponding high-frequency signals in a nuclear spin resonance-apparatus, in particular in medical technology, the device containing a surface coil (12) with several turns for generating a magnetic high-frequency field, orientated essentially in the direction of the y-axis of an x-y-z right-angled coordinate system, perpendicular to the surface (3) of a body (4) to be examined, the surface coil (12) to be arranged on the surface (3) of the body (4) within an at least approximately homogeneous base field (B₀), along the z-axis, parallel to the surface (3) of the body (4), characterised by the following design features:

a) the turns (16, 19, 27; 17, 18, 28; 13, 24, 22, 29, 30; 14, 25, 21, 32; 15, 26, 20, 31) of the surface coil (12) contain as magnetically active parts longitudinal conducting parts (13 to 22), from which in each case both longitudinal conducting parts (13 or 22, 14 or 21; 15 or 20, 16 or 19 and 17 or 18) belonging to the same turn are arranged symmetrically to the x-axis,

b) several outer turns (13, 24, 22, 29, 30; 14, 25, 21, 32; 15, 26, 20, 31) enclose at least one inner turn (16, 19, 27; 17, 18, 28),

c) the longitudinal conducting parts (13 to 15 or 20 to 22) of the outer turns (13, 24, 22, 29, 30; 14, 25, 21, 32; 15, 26, 20, 31) with the same current direction in relation to the x-axis form in each case an outer group (G$_2$; G'$_2$) consisting of neighbouring longitudinal conducting pieces,

d) the conduction directions of these groups (G$_2$, G'$_2$) are in relation to the x-axis directed against each other,

e) the conduction direction in each case of one of the outer groups (G$_2$, G'$_2$) is directed against the conduction direction of the neighbouring longitudinal conducting part of the inner turn.

2. Device according to claim 1, characterised in that several inner turns (16, 19, 27 and 17, 18, 28) are provided, the neighbouring longitudinal conducting parts (16, 17; 18, 19) of which, of the same conduction direction in relation to the x-axis, form in each case an inner group (G$_1$ or G'$_1$).

3. Device according to claim 1 or 2, characterised in that a surface coil (12) is provided with an essentially rectangular form, the longitudinal conducting parts (13 to 22) extending parallel are essentially longer than the transverse conducting parts (24 to 32) connecting them and that the longitudinal conducting parts (13 to 22) are arranged at least substantially perpendicular to the direction of orientation of the magnetic base field (B$_0$).

4. Device according to claim 2 or 3, characterised in that the number (n$_1$) of the longitudinal conducting parts (16 to 19) of the inner turns is smaller than the number (n$_2$) of conducting parts (13 to 15 and 20 to 22) of the outer turns enclosing them.

5. Device according to one of claims 2 and 4, characterised in that the outer groups (G$_2$, G'$_2$) and the inner groups (G$_1$, G'$_1$) are arranged in each case symmetrically to the x-axis.

6. Device according to one of claims 2 to 5, characterised in that the inner groups (G$_1$, G'$_1$) include in each case two longitudinal conducting parts (16, 17 or 18, 19) and the outer groups (G$_2$, G'$_2$) in each case three longitudinal conducting parts (13 to 15 or 20 to 22).

7. Device according to claim 5 or 6, characterised in that the distance (d$_1$) of the inner groups (G$_1$, G'$_1$) from the x-axis in relation to the corresponding distance (d) of the outer groups (G$_2$, G'$_2$) is selected approximately as

$$\frac{d_1}{d_2} = \frac{n_1}{n_2}$$

8. Device according to one of claims 3 to 7, characterised in that the shortest longitudinal conducting part (13 to 22) of the surface coil (12) is at least three times longer than its respective associated transverse conducting part (24 to 32).

9. Device according to one of claims 3 to 8, characterised in that the transverse conducting parts (24 to 32) are screened high-frequency-wise.

10. Device according to one of claims 3 to 8, characterised in that the clearance of the transverse conducting parts (24 to 32) from the surface (3) of the part of the body (4) to be examined is larger than the clearance of the longitudinal conducting parts (13 to 22).

11. Device according to one of claims 1 to 10, characterised in that neighbouring longitudinal conducting parts (36 to 38 or 39 to 41) forming a further group (G$_3$, G'$_3$) are at least partly arranged on different planes.

**Revendications**

1. Dispositif pour la génération d'un champ magnétique haute fréquence et/ou pour réceptionner des signaux haute fréquence dans un appareil à résonance de spin nucléaire, notamment de la technique médicale, du type qui comprend une bobine de surface (12) à plusieurs spires, pour engendrer un champ magnétique haute fréquence orienté essentiellement dans la direction de l'axe y d'un système de coordonnées rectangulaires, perpendiculaire à la surface (3) du corps (4) à examiner, et dans lequel la bobine de surface (12) doit être disposée sur la surface (3) du corps (4), et à l'intérieur d'un champ magnétique fondamental (B$_0$) au moins approximativement homogène et orienté le long de l'axe z, parallèlement à la surface (3) du corps (4), caractérisé par le fait que:

a) les spires (16, 19, 27; 17, 18, 28; 13, 24, 22, 29, 30; 14, 25, 21, 32; 15, 26, 20, 31) de la bobine de surface (12) comportent, comme parties magnétiquement actives, des tronçons conducteurs longitudinaux (13 à 22), deux tronçons conducteurs longitudinaux (13 ou 22, 14 ou 21; 15 ou 20, 16 ou 19 et 17 ou 18) qui appartiennent à la même spire étant respectivement disposés symétriquement par rapport à l'axe x;

b) plusieurs spires extérieures (13, 24, 22, 29, 30; 14, 25, 21, 32; 15, 26, 20, 31) entourent au moins une spire intérieure (16, 19, 27; 17, 18, 28);

c) les tronçons conducteurs longitudinaux (13 à 15 ou 20 à 22) des spires extérieures (13, 24, 22, 29, 30; 14, 25, 21, 32; 15, 26, 20, 31) ayant le même sens du courant par rapport à l'axe x constituent respectivement un groupe extérieur (G$_2$; G'$_2$) composé de tronçons conducteurs longitudinaux voisins ;

d) les sens de passage du courant de ces groupes (G$_2$; G'$_2$) sont opposés l'un à l'autre par rapport à l'axe x;

e) le sens de passage du courant de chacun des groupes extérieurs (G$_2$; G'$_2$) est opposé au sens de passage du courant du tronçon conducteur longitudinal voisin, de la spire intérieure.

2. Dispositif selon la revendication 1, caractérisé en ce que plusieurs spires intérieures (16, 19, 27 et 17, 18, 28) sont prévues, dont les tronçons conducteurs longitudinaux (16, 17; 18, 19) voisins et de même sens de passage du courant constituent à chaque fois un groupe intérieur (G$_1$ ou G'$_1$) par rapport à l'axe x.

3. Dispositif selon la revendication 1 ou 2, caractérisé en ce qu'une bobine de surface (12) avec une structure essentiellement rectangulaire est prévue, dont les tronçons conducteurs longitudinaux (13 à 22), qui s'étendent en parallèle sont sensiblement plus longs que les tronçons conducteurs transversaux (24 à 32) qui les relient, et que les tronçons conducteurs longitudinaux (13 à 22) sont disposés au moins en s'étendant perpendiculairement à la direction de l'orientation du champ magnétique fondamental $(B_0)$.

4. Dispositif selon la revendication 2 ou 3, caractérisé en ce que le nombre $(n_1)$ de tronçons conducteurs longitudinaux (16 à 19) des spires intérieures est inférieur au nombre $(n_2)$ de tronçons conducteurs (13 à 15 et 20 à 22) des spires extérieures qui les entourent.

5. Dispositif selon une des revendications 2 et 4, caractérisé en ce que les grounes extérieurs $(G_2; G'_2)$ et les groupes intérieurs $(G_1; G'_1)$ sont à chaque fois disposés symétriquement à l'axe x.

6. Dispositif selon une des revendications 2 à 5, caractérisé en ce que les groupes intérieurs $(G_1; G'_1)$ comportent chacun deux tronçons conducteurs longitudinaux (16, 17 ou 18, 19) et les groupes extérieurs $(G_2; G'_2)$ comportent chacun deux tronçons conducteurs longitudinaux (13 à 15 ou 20 à 22).

7. Dispositif selon la revendication 5 ou 6, caractérisé en ce que la distance $(d_1)$ des groupes intérieurs $(G_1; G'_1)$ à l'axe x est choisie, en fonction de la distance $(d_2)$ correspondante des groupes extérieurs $(G_2; G'_2)$ à peut près suivant la relation:

$$\frac{d_1}{d_2} = \frac{n_1}{n_2}$$

8. Dispositif selon une des revendications 3 à 7, caractérisé en ce que le plus court tronçon conducteur longitudinal (13 à 22) de la bobine de surface (12) est au moins trois fois plus long que le tronçon conducteur transversal (24 à 32) qui lui est conjugué.

9. Dispositif selon une des revendications 3 à 8, caractérisé en ce que les tronçons conducteurs transversaux (24 à 32) sont antiparasités contre les hautes fréquences.

10. Dispositif selon une des revendications 3 à 8, caractérisé en ce que la distance entre les tronçons conducteurs transversaux (24 à 32) et la surface (3) de la partie du corps (4) à examiner est plus grande que la distance entre les tronçons conducteurs longitudinaux (13 à 22).

11. Dispositif selon une des revendications 1 à 10, caractérisé en ce que des tronçons conducteurs longitudinaux voisins (36 à 38 ou 39 à 41) qui forment un groupe supplémentaire $(G_3; G'_3)$ sont disposés au moins partiellement dans des plans différents.

EP 0 142 077 B1

FIG 1

FIG 2

1

FIG 3

FIG 5

FIG 4